# EUROPEAN PATENT APPLICATION

(11) **EP 2 028 667 A2**
(43) Date of publication of application: **25.02.2009**
(21) Application number: 08154241.7
(22) Date of filing: 09.04.2008
(51) Int. Cl.: H01G 9/20

(54) **Dye-sensitized solar cell and method of manufacturing the same**

(30) Priority: 21.08.2007 KR 20070083952
(71) Applicant: Electronics and Telecommunications Research Institute, Daejeon-shi (KR)
(72) Inventor: JUN, Yong Seok, Daejeon-city (KR); KANG, Man Gu, Daejeon-city (KR); KIM, Jong Dae, Daejeon-city (KR); YUN, Ho Gyeong, Seoul (KR); LEE, Seung Yup, Gyeongsan-city, Kyungsangbuk-do (KR); PARK, Jong Hyeok, Daejeon-city (KR); PARK, Hun Kyun, Daejeon-city (KR)
(74) Representative: Betten & Resch

(57) **Abstract**

Provided are a dye-sensitized solar cell including a semiconductor electrode on which an insulating protective layer formed by self-assembling organic molecules dissolved in an electrolyte solution is formed, and a method of manufacturing the dye-sensitized solar cell, The dye-sensitized solar cell includes: a semiconductor electrode comprising: a metal oxide layer formed on a first conductive substrate; a dye molecule layer absorbed onto a surface of the metal oxide layer; and an insulating protective layer formed on at least one of a first portion of the surface of the metal oxide layer which is not covered by the dye molecule layer and a second portion of a surface of the first conductive substrate which does not contact the metal oxide layer; an opposite electrode disposed on a second conductive substrate and facing the semiconductor electrode; and an electrolyte solution filled in a space between the semiconductor electrode and the opposite electrode and including organic molecules having a functional group, which can be selectively self-assembled by a chemical bond with a metal oxide on the metal oxide, dissolved therein. Once the electrolyte solution is injected between the semiconductor electrode and the opposite electrode, the electrolyte solution contacts an electron transport layer and thus the organic molecules are self-assembled on the first portion or the second portion to form the insulating protective layer.

## Description

### CROSS-REFERENCE TO RELATED PATENT APPLICATION

This application claims the benefit of Korean Patent Application No. 10-2007-0083952, filed on August 21, 2007, in the Korean Intellectual Property Office, the disclosure of which is incorporated herein in its entirety by reference.

### BACKGROUND OF THE INVENTION

### 1. Field of the Invention

The present invention relates to a solar cell and a method of manufacturing the same, and more particularly, to a dye-sensitized solar cell including a metal oxide layer on which dye molecules are coated and a method of manufacturing the dye-sensitized solar cell. This work was supported by the IT R&D program of MIC/IITA. [2006-S-006-02, Components/Module technology for Ubiquitous Terminals]

### 2. Description of the Related Art

Unlike conventional p-n junction silicon solar cells, dye-sensitized solar cells are photo-electrochemical solar cells that primarily use photosensitive dye molecules capable of generating electron-hole pairs by absorbing visible light, and a transition metal oxide transporting the generated electrons. Graetzel cells disclosed in U.S. Patent Nos. 4,927,721 and 5,350,644, issued to Graetzel et al. (Switzerland) are representative dye-sensitized solar cells. These dye-sensitized solar cells are photo-electrochemical solar cells that include a semiconductor electrode formed of a nanoparticle titanium dioxide (TiO₂) layer onto which dye molecules are adsorbed, an opposite electrode coated with platinum or carbon, and an electrolyte solution filled between the semiconductor electrode and the opposite electrode. The dye-sensitized solar cells can offer lower manufacturing costs per unit of power than conventional silicon solar cells and thus have attracted widespread interest as promising substitutes for conventional solar cells.

The principle of operation of the dye-sensitized solar cells will now be explained. Electrons are injected into a conduction band of the nanoparticle TiO₂ layer from photosensitive dyes excited by sunlight. The injected electrons pass through the nanoparticle TiO₂ layer to reach a conductive substrate and are transported to an external circuit. After performing electrical work in the external circuit, the electrons are transported back into the nanoparticle TiO₂ layer through the opposite electrode by an oxidation/reduction electrolyte so as to reduce photosensitive dyes having insufficient electrons, thereby completing the operation of the dye-sensitized solar cells. Here, when the electrons injected from the photosensitive dyes pass through the nanoparticle TiO₂ layer and the conductive substrate before reaching the external circuit, some of the injected electrons may remain in an empty surface energy level on the surface of the nanoparticle TiO₂ layer.. If there is a portion of the surface of the nanoparticle TiO₂ layer onto which the photosensitive dyes are not adsorbed and thus which is exposed to the electrolyte solution, or if there is a portion of the surface of the conductive substrate constituting the semiconductor electrode which does not contact the nanoparticle TiO₂ layer and thus is exposed to the electrolyte solution, the electrons remaining in the empty surface energy level react with the oxidation/reduction electrolyte, and are removed inefficiently instead of moving through the circuit. In addition, the electrons generated by light may also react with the oxidation/reduction electrolyte and may be removed on the surface of the conductive substrate, thereby decreasing energy conversion efficiency.

### SUMMARY OF THE INVENTION

The present invention provides a dye-sensitized solar cell that can prevent electron loss due to an interaction between an oxidation/reduction electrolyte and electrons injected from photosensitive dyes on a surface of a metal oxide layer or on a surface of a conductive substrate.

The present invention also provides a method of manufacturing a dye-sensitized solar cell which can prevent electron loss due to an interaction between an oxidation/reduction electrolyte and electrons injected from photosensitive dyes on a surface of a metal oxide layer or on a surface of a conductive substrate.

According to an aspect of the present invention, there is provided a dye-sensitized solar cell comprising: a semiconductor electrode comprising: a metal oxide layer formed on a first conductive substrate; a dye molecule layer absorbed onto a surface of the metal oxide layer; and an insulating protective layer formed on at least one of a first portion of the surface of the metal oxide layer which is not covered by the dye molecule layer and a second portion of a surface of the first conductive substrate which does not contact the metal oxide layer; an opposite electrode disposed on a second conductive substrate and facing the semiconductor electrode; and an electrolyte solution filled in a space between the semiconductor electrode and the opposite electrode and including organic molecules having a functional group, which can be selectively self-assembled by a chemical bond with a metal oxide on the metal oxide, dissolved therein..

The insulating protective layer may comprise a self-assembled molecule layer formed of an insulating organic material which is self-assembled by a chemical bond on at least one of the first portion and the second portion.

According to another aspect of the present invention, there is provided a method of manufacturing a dye-sensitized solar cell, the method comprising: forming a semiconductor electrode comprising an electron transport layer that comprises a metal oxide layer disposed on a first conductive substrate and a dye molecule layer absorbed onto a surface of the metal oxide layer; forming an opposite electrode on a second conductive substrate; aligning the semiconductor electrode and the opposite electrode to face each other; and injecting an electrolyte solution in which organic molecules having a functional group which can be selectively self-assembled by a chemical bond with a metal oxide on the metal oxide are dissolved into a space between the semiconductor electrode and the opposite electrode and contacting the electrolyte solution with the electron transport layer.

The semiconductor electrode may comprise a first portion of the surface of the metal oxide layer which is not covered by the dye molecule layer and a second portion of a surface of the first conductive substrate which does not contact the metal oxide layer, wherein the contacting of the electrolyte solution with the electron transport layer comprises self-assembling the organic molecules dissolved in the electrolyte solution on at least one of the first portion and the second portion so that an insulating protective layer can be formed on at least one of the first portion and the second portion.

The organic molecules may comprise at least one selected from the group consisting of a silane compound, a phosphate compound, a sulfuric acid compound, and a carboxylic acid compound.

### BRIEF DESCRIPTION OF THE DRAWINGS

The above and other features and advantages of the present invention will become more apparent by describing in detail exemplary embodiments thereof with reference to the attached drawings in which:
FIG. 1 is a cross-sectional view of a dye-sensitized solar cell according to an embodiment of the present invention;
FIG. 2 is an enlarged cross-sectional view of a semiconductor electrode of the dye-sensitized solar cell of FIG. 1, according to an embodiment of the present invention; and

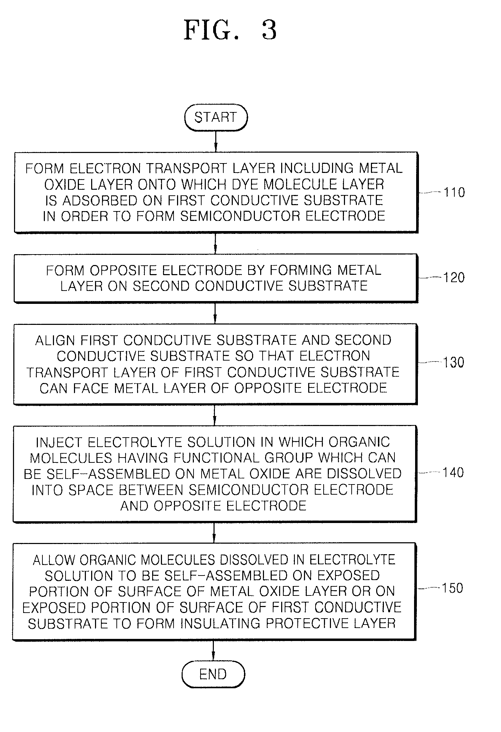

FIG. 3 is a flowchart illustrating a method of manufacturing the dye-sensitized solar cell of FIG. 1, according to an embodiment of the present invention.

### DETAILED DESCRIPTION OF THE INVENTION

The present invention will now be described more fully with reference to the accompanying drawings, in which exemplary embodiments of the invention are shown.

The invention may, however, be embodied in different forms and should not be construed as limited to the embodiments set forth herein. Rather, these embodiments are provided so that this disclosure will be thorough and complete, and will fully convey the scope of the invention to those skilled in the art. In the drawings, the thicknesses of layers and regions and the sizes of components may be exaggerated for clarity.

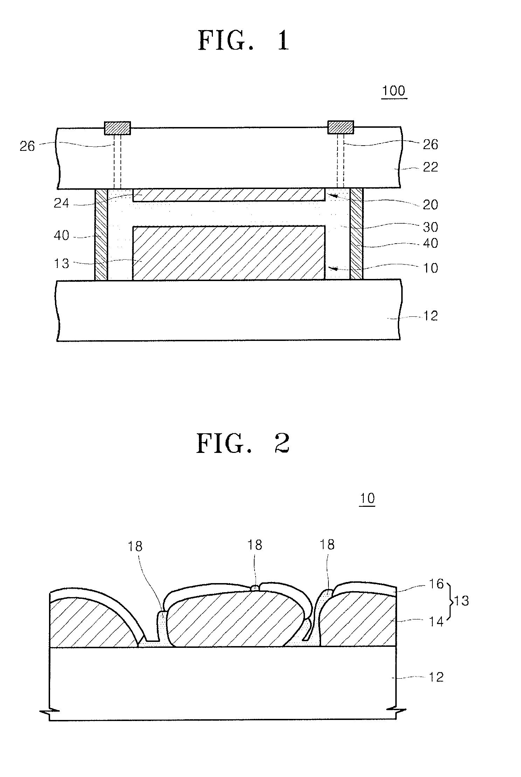

FIG. 1 is a cross-sectional view of a dye-sensitized solar cell 100 according to an embodiment of the present invention.

Referring to FIG.. 1, the dye-sensitized solar cell 100 according to the current embodiment of the present invention includes a semiconductor electrode 10, an opposite electrode 20 facing the semiconductor electrode 10, and an electrolyte solution 30 filled between the semiconductor electrode 10 and the opposite electrode 20.

Organic molecules having a functional group which can be selectively self-assembled by a chemical bond with a metal oxide on the metal oxide are dissolved in the electrolyte solution 30. The organic molecules dissolved in the electrolyte solution 30 may be formed of a silane compound, a phosphate compound, a sulfuric acid compound, or a carboxylic acid compound. This will be explained later in detail.

FIG. 2 is an enlarged cross-sectional view of the semiconductor electrode 10 of the dye-sensitized solar cell 100 of FIG. 1, according to an embodiment of the present invention.

Referring to FIGS.. 1 and 2, the semiconductor electrode 10 according to the current embodiment of the present invention includes a transparent first conductive substrate 12, and an electron transport layer 13 formed on the first conductive substrate 12 to transport electrons to the first conductive substrate 12. The electron transport layer 13 includes a metal oxide layer 14 formed on the first conductive substrate 12, and a dye molecule layer 16 adsorbed onto a surface of the metal oxide layer 14.

An insulating protective layer 18 for preventing inefficient electron loss due to an interaction with the electrolyte solution 30 is formed on a portion of the surface of the metal oxide layer 14 which is not covered by the dye molecule layer 16 and on a portion of a surface of the first conductive substrate 12 which does not contact the metal oxide layer 14. The insulating protective layer 18 is formed of an insulating organic material having no capacity to transport electrons or holes. The insulating protective layer 18 may be formed of an organic material self-assembled on the surface of the metal oxide layer 14 and on the surface of the first conductive substrate 12. In particular, the insulating protective layer 18 may include a self-assembled molecule layer formed by self-assembling the organic molecules dissolved in the electrolyte solution 30 on the surface of the metal oxide layer 14 and on the surface of the first conductive substrate 12. The insulating protective layer 18 may be formed of a silane compound, a phosphate compound, a sulfuric acid compound, or a carboxylic acid compound. This will be explained later in detail.

The first conductive substrate 12 may be formed of indium tin oxide (ITO), fluorine-doped tin oxide (FTO), or a glass substrate on which SnO₂ is coated.

The metal oxide layer 14 may be formed of titanium dioxide (TiO₂), tin-dioxide (SnO₂), zinc oxide (ZnO), or a combination thereof. The metal oxide layer 14 may have a thickness of about 5 to 15 µm.

The dye molecule layer 16 may be formed of a ruthenium complex.

The insulating protective layer 18 including a self-assembled molecule layer formed by self-assembling the organic molecules dissolved in the electrolyte solution 30 on the surface of the metal oxide layer 14 and on the surface of the first conductive substrate 12may be a one-molecule layer. The thickness of the insulating protective layer 18 may be adjusted according to the molecular length of materials forming the one-molecular layer.

The source compound of the self-assembled molecule layer may be selected from organic molecules having a functional group which can be selectively self-assembled by a chemical bond on a metal oxide. In this regard, the organic molecules may include a silane compound, a phosphate compound, a sulfuric acid compound, or a carboxylic acid compound. As described above, the self-assembled molecule layer may be formed of the organic molecules dissolved in the electrolyte solution 30. The insulating protective layer 18 may be formed when the electrolyte solution 30 in which the organic molecules are dissolved contacts at least one of the surface of the metal oxide layer 14 and the surface of the first conductive substrate 12 and the organic molecules dissolved in the electrolyte solution 30 are self-assembled on at least one of the surface of the metal oxide layer 14 and the surface of the first conductive substrate 12. The organic molecules constituting the self-assembled molecule layer will be explained later in detail.

Referring back to FIG. 1, the opposite electrode 20 includes a second conductive substrate 22 and a metal layer 24 coated on the second conductive substrate 22. The metal layer 24 may be a platinum layer. The conductive substrate 22 may be formed of ITO, FTO, or a glass substrate on which SnO₂ is coated.

The metal layer 24 of the opposite electrode 20 is disposed to face the electron transport layer 13 of the semiconductor electrode 10.

The electrolyte solution 30 filled in a space between the semiconductor electrode 10 and the opposite electrode 20 may include an imidazole-based compound and iodine. For example, the electrolyte solution 30 may include a I₃⁻/I⁻ electrolyte solution composed of 0.70 M 1-vinyl-3-methyl-immidazolium iodide, 0.10 M Lil, 40 mM iodine (I₂), and 0.125 M 4-tert-butylpyridine in 3-methoxypropionitrile.

The organic molecules having a functional group which can be selectively self-assembled on the metal oxide layer 14 by a chemical bond with the metal oxide are dissolved in the electrolyte solution 30 as described above. The organic molecules dissolved in the electrolyte solution 30 may be formed of a silane compound, a phosphate compound, a sulfuric acid compound, or a carboxylic acid compound.

The concentration of the organic molecules in the total amount of the electrolyte solution 30 may be about 0.001 to 1 M.

The electrolyte solution 30 is injected through a micro hole 26 formed in the second conductive substrate 22 of the opposite electrode 20 into the space defined by a polymer layer 40 between the semiconductor electrode 10 and the opposite electrode 20.

The operation of the dye-sensitized solar cell 100 of FIG. 1 constructed as described above will now be explained.

When sunlight which penetrates the first conductive substrate 12 of the semiconductor electrode 10 is absorbed into the dye molecule layer 16 adsorbed onto the metal oxide layer 14, materials of the dye molecule layer 16 are excited and thus electrons are injected into a conduction band of the metal oxide layer 14. The electrons injected into the metal oxide layer 14 are delivered to the first conductive substrate 12, which contacts the metal oxide layer 14, through an interface between nano-scale fine particles constituting the metal oxide layer 14 and then are transported to the opposite electrode 20 through an external electric wire (not shown).

The dye molecule layer 16, which is oxidized as a result of an electron transition, receives electrons provided by an oxidation-reduction action (3I⁻ → I₃⁻ + 2e⁻) of iodine ions disposed in the electrolyte solution 30 and the electrons are reduced again. The oxidized iodine ions (I₃⁻) are reduced again by the electrons reaching the opposite electrode 20, thereby completing the operation of the dye-sensitized solar cell 100.

As described above, in the operation of the dye-sensitized solar cell 100, since the portion of the first conductive substrate 12 of the semiconductor electrode 10 which does not contact the metal oxide layer 14 and the portion of the metal oxide layer 14 of the semiconductor electrode 10 which is not covered by the dye molecule layer 16 are covered by the insulating protective layer 18, a path through which electron loss easily occurs cannot be formed due to the insulating protective layer 18 and thus energy conversion efficiency can be improved significantly.

FIG.. 3 is a flowchart illustrating a method of manufacturing the dye-sensitized solar cell 100 of FIG.. 1, according to an embodiment of the present invention.

In operation 110, in order to form a semiconductor electrode 10 including an electron transport layer 13, a metal oxide layer 14 onto which a dye molecule layer 16 is adsorbed is formed on a first conductive substrate 12.

To this end, the first conductive substrate 12 on which the metal oxide layer 14 is formed is prepared. The metal oxide layer 14 may be formed to a thickness of 5 to 15 µm. The dye molecule layer 16 is coated on a surface of the metal oxide layer 14 by immersing the first conductive substrate 12 on which the metal oxide layer 14 is formed in a dye solution composed of a ruthenium complex for 24 hours or more.

The resultant structure on which the dye molecule layer 16 is formed is dried in an N₂ atmosphere to remove an alcohol-based organic solvent from a surface of the resultant structure.

A portion of the surface of the metal oxide layer 14 onto which the dye molecule layer 16 is not adsorbed may be exposed. Also, a portion of a surface of the first conductive substrate 12 which does not contact the metal oxide layer 14 may be exposed.

In operation 120, in order to form an opposite electrode 20, a metal layer 24, e.g., a platinum layer, is coated on a second conductive substrate 22.

In operation 130, the first conductive substrate 12 and the second conductive substrate 22 are aligned with each other so that the electron transport layer 13 formed on the first conductive substrate 12 can face the metal layer 24 of the opposite electrode 20 formed on the second conductive substrate 22.

To this end, a polymer layer 40, which may have a thickness of about 30 to 50 µm and may be formed of SURLYN (manufactured by Du Pont), is interposed between the first conductive substrate 12 and the second conductive substrate 22, and the first conductive substrate 12 and the second conductive substrate 22 are attached to each other on a heating plate at a temperature of 100 to 140°C under an atmospheric pressure of 1 to 3 such that a relatively small gap is formed between the first conductive substrate 12 and the second conductive substrate 22. Due to heat and pressure, the polymer layer 40 is strongly attached onto surfaces of both the semiconductor electrode 10 and the opposite electrode 20.

In operation 140, an electrolyte solution 30 is injected through a micro hole 26 formed in the second conductive substrate 22 into a space between the semiconductor electrode 10 and the opposite electrode 20. Organic molecules having a functional group which can be selectively self-assembled on a metal oxide by a chemical bond with the metal oxide are dissolved in the electrolyte solution 30.

After the injection of the electrolyte solution 30, SURLYN and a thin glass are rapidly heated to close the micro hole 26.

In operation 150, the organic molecules dissolved in the electrolyte solution 30 are self-assembled on at least one of the exposed portion of the surface of the metal oxide layer 14 and on the exposed portion of the surface of the first conductive substrate12 to form an insulating protective layer 18.

In order to form the insulating protective layer 18 as a self-assembled organic layer, the organic molecules dissolved in the electrolyte solution 30 may be selected from insulating organic materials that cannot transport electrons or holes. In particular, the organic molecules may be selected from organic molecules having a functional group which can be selectively self-assembled by a chemical bond only on a surface of a metal oxide. In this regard, the organic molecules may include a silane compound, a phosphate compound, a sulfuric acid compound, or a carboxylic acid compound.

When a silane compound is used as the source material of the organic molecules, the silane compound may have a structure selected from the group consisting of R₁SiHR₂R₃, R₁SiXR₂R₃ (X is Cl, Br, or I), and R₁SiRR₂R₃ (R is methoxy, ethoxy, or t- butoxy), where R₁, R₂, and R₃ are a C₁-C₂₄ alkane, an alkene, or alkynes, and each of R₁, R₂, and R₃ is substituted or unsubstituted with fluorine. For example, the silane compound may be alkylsilane, alkyltrichlorosilane, alkoxy alkylsilane, trialkoxy alkylsilane, or dialkoxy dialkylsilane including a C₁-C₂₄ alkyl group or alkoxy group.

When a phosphate compound is used as the source material of the organic molecules, the phosphate compound may have a functional group selected from -PO₄, -PO₃, -PO₂, and - PO. The phosphate compound may have a structure of PR₁R₂R₃R₄, where R₁, R₂, R₃, and R₄ are C₁-C₂₄ alkane, alkene, or alkynes, each of R₁, R₂, R₃ and R₄ is substituted or unsubstituted with fluorine, and at least one of R₁, R₂, R₃, and R₄ is -OH or -O. When at least one of R₁, R₂, R₃, and R₄ is -O, the phosphate compound may exist in the form of a complex having a metal ion. For example, the phosphate compound may be an alkyl phosphoric acid, alkyl hyposphorous acid, or phosphorous acid having a C₁-C₂₄ alkyl group substituted or unsubstituted with fluorine.

When a sulfuric acid compound is used as the source material of the organic molecules, the sulfuric acid compound may have a functional group selected from -SO₄, -SO₃, -SO₂, and -SO. The sulfuric acid compound may have a structure of SR₁R₂R₃R₄, where R₁, R₂, R₃, and R₄ are C₁-C₂₄ alkane, alkene, or alkynes, each of R₁, R₂, R₃ and R₄ is substituted or unsubstituted with fluorine, and at least one of R₁, R₂, R₃, and R₄ is -OH or -O. When at least one of R₁, R₂, R₃, and R₄ is -O, the sulfuric acid compound may exist in forms of a complex having a metal ion. For example, the sulfuric acid compound may be sulfuric acid, sulfurous acid, or a metal-ion complex thereof, i.e., sodium sulfate and potassium sulfite.

When a carboxylic acid compound is used as the source material of the organic molecules, the carboxylic acid compound may have a functional group of -COOH or -COO⁻. The carboxylic acid compound may have a structure of R₁COOH or R₂COO⁻, where R₁ and R₂ are C₁-C₂₄ alkane, alkene, or alkynes, and each of R₁ and R₂ is substituted or unsubstituted with fluorine. For example, the carboxylic acid compound may be methanoic acid, ethanoic acid, propanoic acid, butanoic acid, malonic acid, oxalic acid, succinic acid, phthalic acid, glutaric acid, adipic acid, or benzoic acid.

As described above, once the electrolyte solution 30 is injected between the first conductive substrate 12 and the second conductive substrate 22 in operation 150, the electrolyte solution 30 contacts the electron transport layer 13 of the first conductive substrate 12 such that the organic molecules dissolved in the electrolyte solution 30 are self-assembled on the portion of the surface of the metal oxide layer 14 which is not covered by the dye molecule layer 16 and the portion of the surface of the first conductive substrate 12 which does not contact the metal oxide layer 14 to form the insulating protective layer 18. Due to the insulating protective layer 18, inefficient electron loss due to an interaction with the electrolyte solution 30 can be prevented when the electrons injected into the metal oxide layer 14 from the electron transport layer 13 are transported to the external circuit through the first conductive substrate 12.

An example of manufacturing a dye-sensitized solar cell according to the present invention will now be described in detail.

### Example 1

### Manufacturing of dye-sensitized solar cell

A first TiO₂ nano-particle layer was formed on a FTO substrate by screen printing using synthesized TiO₂ paste, and then was dried and sintered at a temperature of 500 °C. A second TiO₂ nano-particle layer including light scattering particles having a diameter of 200 to 400 nm was formed on the first TiO₂ nano-particle layer by screen printing ,and then was dried and sintered to manufacture a TiO₂ thin film in the form of a double-layered structure having a thickness of 20 µm.

The resultant structure on which the TiO₂ thin film was formed was added to an alcoholic solution in which ruthenium dye (4,4'-dicarboxy-2,2-bupyridine)bis(thiocyanato)ruthenium(II): N3) was dissolved, and the dye was adsorbed onto a surface of the TiO₂ thin film.. The resultant structure onto which the dye was adsorbed was washed using ethanol and dried to form a semiconductor electrode.

A conductive glass substrate on which a H₂PtCl₆ solution was coated was heated for 30 minutes at a temperature 450 °C to prepare counter electrodes.

The semiconductor electrodes and the counter electrodes were aligned so their respective conductive surfaces faced each other. Then, a polymer layer formed of SURLYN (manufactured by Du Pont) was interposed between the semiconductor electrodes and the counter electrodes to adhere the semiconductor electrodes and the counter electrodes together so that a relatively small gap was formed therebetween. Samples prepared after performing such a process were divided into three groups.

Next, I₃⁻/I⁻ electrolyte solutions having different compositions were injected into spaces between the semiconductor electrodes and the counter electrodes in the prepared three groups of samples to complete the manufacture of dye-sensitized solar cells. The compositions of the electrolyte solutions injected into the samples are shown in Table 1 below.

**Table 1**

| Constituent | Lil (M) | MBII (M) | I₂ (M) | t-bPyridine (M) | guanidinium thiocyanate (M) |
|---|---|---|---|---|---|
| Sample 1 | 0.02 | 0.6 | 0.04 | 0.28 | 0.05 |
| Sample 2 | - | 0.6 | 0.03 | 0.5 | 0.1 |
| Sample 3 | 0.04 | 0.005 | 0.02 | 0.5 | - |

In Table 1, MBII denotes methylbuthylimidazolium iodide, t-bPyridine denotes tertiary buthylpyridine.

As shown in Table 1, 0.05 M guanidinium thiocyanate and 0.1 M guanidinium thiocyanate were added as organic molecules respectively to the electrolyte solutions injected into Sample 1 and Sample 2. The guanidinium thiocyanate was self-assembled on a portion of the TiO₂ thin film which does not allow dye adsorption and thus contacts the electrolyte solution and on a portion of the FTO substrate which does not contact the TiO₂ thin film and thus contacts the electrolyte solution to form an insulating protective layer.

No guanidinium thiocyanate was added to Sample 3.

### Example 2

### Evaluation of light conversion efficiency

In order to evaluate light conversion efficiency of the dye-sensitized solar cells of Samples 1 through 3 manufactured in Example 1, photo voltages and photo currents of the dye-sensitized solar cells were measured as follows To this end, a solar simulator including a source meter (Keithley 2400 SourceMeter^{®}) was used. Here, a Xenon lamp (Oriel, 91193) was used as a light source.

Voltages and short-circuit currents of the dye-sensitized solar cells of Samples 1 through 3 manufactured in Example 1 were measured and the results are shown in Table 2 below.

**Table 2**

| Characteristics | V_{oc}(V) | J_{sc} (mA/cm²) | FF | Eff (%) |
|---|---|---|---|---|
| Sample 1 | 0.77 | 11 | 72 | 6.1 |
| Sample 2 | 0.81 | 11.25 | 74 | 6.74 |
| Sample 3 | 0.74 | 11.3 | 55 | 4.43 |

In Table 2, V_{oc} denotes an open-circuit voltage, J_{sc} denotes a short-circuit current, FF denotes a fill factor, and Eff denotes efficiency.

As shown in Table 2, Samples 1 and 2 into which the electrolyte solutions including the organic molecules which are self-assembled on the surface of the TiO₂ thin film and on the surface of the FTO substrate to form the insulating protective layers are injected have higher open-circuit voltages and higher efficiency than Sample 3 into which the electrolyte solution not including the organic molecules is injected.

As described above, according to the dye-sensitized solar cell of the present invention, since an insulating protective layer is formed on a surface of a metal oxide layer which can contact an oxidation/reduction electrolyte, and on a surface of a conductive substrate, electron loss easily occurring when electrons generated by the photovoltaic effect are transported to an external circuit can be prevented, thereby significantly improving energy conversion efficiency.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A dye-sensitized solar cell comprising:
a semiconductor electrode comprising:
a metal oxide layer formed on a first conductive substrate;
a dye molecule layer absorbed onto a surface of the metal oxide layer; and
an insulating protective layer formed on at least one of a first portion of the surface of the metal oxide layer which is not covered by the dye molecule layer and a second portion of a surface of the first conductive substrate which does not contact the metal oxide layer;
an opposite electrode disposed on a second conductive substrate and facing the semiconductor electrode; and
an electrolyte solution filled in a space between the semiconductor electrode and the opposite electrode and including organic molecules having a functional group, which can be selectively self-assembled by a chemical bond with a metal oxide on the metal oxide, dissolved therein.

2. The dye-sensitized solar cell of claim 1, wherein the insulating protective layer comprises a self-assembled molecule layer formed of an insulating organic material which is self-assembled by a chemical bond on at least one of the first portion and the second portion.

3. The dye-sensitized solar cell of claim 2, wherein the insulating protective layer comprises a self-assembled molecule layer formed of at least one compound selected from the group consisting of a silane compound, a phosphate compound, a sulfuric acid compound, and a carboxylic acid compound each of which is self-assembled on at least one of the first portion and the second portion.

4. The dye-sensitized solar cell of claim 3, wherein the compound has the same structure as that of the organic molecules dissolved in the electrolyte solution.

5. The dye-sensitized solar cell of any of the preceding claims, wherein the organic molecules dissolved in the electrolyte solution comprise a silane compound having a structure selected from the group consisting of R₁SiHR₂R₃, R₁SiXR₂R₃ (X is Cl, Br, or I), and R₁SiRR₂R₃ (R is methoxy, ethoxy, or t-butoxy), where R₁, R₂, and R₃ are C₁-C₂₄ alkane, alkene, or alkynes, and each of R₁, R₂, and R₃ is substituted or unsubstituted with fluorine.

6. The dye-sensitized solar cell of any of the preceding claims, wherein the organic molecules dissolved in the electrolyte solution comprise a phosphate compound having a structure PR₁R₂R₃R₄, where R₁, R₂, R₃, and R₄ are C₁-C₂₄ alkane, alkene, or alkynes, each of R₁, R₂, R₃, and R₄ is substituted or unsubstituted with fluorine, and at least one of R₁, R₂, R₃, and R₄ is -OH or -O.

7. The dye-sensitized solar cell of any of the preceding claims, wherein the organic molecules dissolved in the electrolyte solution comprise a sulfuric acid compound having a structure of SR₁R₂R₃R₄, where R₁, R₂, R₃, and R₄ are a C₁ - C₂₄ alkane, an alkene, or alkynes, each of R₁, R₂, R₃, and R₄ is substituted or unsubstituted with fluorine, and at least one of R₁, R₂, R₃, and R₄ is -OH or -O.

8. The dye-sensitized solar cell of any of the preceding claims, wherein the organic molecules dissolved in the electrolyte solution comprise a carboxylic acid compound having a structure of R₁COOH or R₂COO⁻, where R₁ and R₂ are a C₁ - C₂₄ alkane, an alkene, or alkynes, and each of R₁ and R₂ is substituted or unsubstituted with fluorine.

9. The dye-sensitized solar cell of any of the preceding claims, wherein each of the first conductive substrate and the second conductive substrate is formed of indium tin oxide (ITO), fluorine-doped tin oxide (FTO), or a glass substrate on which SnO₂ is coated.

10. The dye-sensitized solar cell of any of the preceding claims, wherein the dye molecule layer is formed of a ruthenium complex.

11. The dye-sensitized solar cell of any of the preceding claims, wherein the semiconductor oxide layer is formed of titanium dioxide (TiO₂), tin-dioxide (SnO₂), zinc oxide (ZnO), or a combination thereof.

12. The dye-sensitized solar cell of any of the preceding claims, wherein the opposite electrode comprises a metal layer.

13. A method of manufacturing a dye-sensitized solar cell, the method comprising:
forming a semiconductor electrode comprising an electron transport layer that comprises a metal oxide layer disposed on a first conductive substrate and a dye molecule layer absorbed onto a surface of the metal oxide layer;
forming an opposite electrode on a second conductive substrate;
aligning the semiconductor electrode and the opposite electrode to face each other; and
injecting an electrolyte solution in which organic molecules having a functional group which can be selectively self-assembled by a chemical bond with a metal oxide on the metal oxide are dissolved into a space between the semiconductor electrode and the opposite electrode and contacting the electrolyte solution with the electron transport layer.

14. The method of claim 13, wherein the semiconductor electrode comprises a first portion of the surface of the metal oxide layer which is not covered by the dye molecule layer, and a second portion of a surface of the first conductive substrate which does not contact the metal oxide layer,
wherein the contacting of the electrolyte solution with the electron transport layer comprises self-assembling the organic molecules dissolved in the electrolyte solution on at least one of the first portion and the second portion so that an insulating protective layer can be formed on at least one of the first portion and the second portion.

15. The method of claim 13 or 14, wherein the organic molecules comprise at least one selected from the group consisting of a silane compound, a phosphate compound, a sulfuric acid compound, and a carboxylic acid compound.
